# EUROPÄISCHE PATENTSCHRIFT

(11) **EP 1 024 571 B1**
(45) Veröffentlichungstag und Bekanntmachung des Hinweises auf die Patenterteilung: **14.01.2009**
(21) Anmeldenummer: 99120497.5
(22) Anmeldetag: 15.10.1999
(51) Int. Cl.: H02G 5/00

(54) **Anordnung zur niederinduktiven Führung hoher Ströme insbesondere für einen Stromrichter oder dergleichen**
Device for low inductance conducting of high currents, especially for rectifier or the same
Dispositif pour conduire des courants élevés sous faible inductance, en particulier pour redresseur ou similaires

(30) Priorität: 29.01.1999 DE 19903522
(43) Veröffentlichungstag der Anmeldung: 02.08.2000
(73) Patentinhaber: Converteam GmbH, 12277 Berlin (DE)
(72) Erfinder: Jakob, Roland, Dr.-Ing., 12524 Berlin (DE); Pelz, Andreas, Dipl.-Ing., 10318 Berlin (DE); Ehlert, Hans-Jürgen, Dipl.-Ing., 14167 Berlin (DE); Rudniski, David, Dipl.-Ing., Toronto, Ontario, Canada M6P 3B2 (US)
(74) Vertreter: Schäfer, Wolfgang

(56) Entgegenhaltungen:
- EP-A- 0 783 199
- DE-A- 4 314 634

## Beschreibung

Die Erfindung betrifft eine Anordnung zur niederinduktiven Führung hoher Ströme insbesondere für einen Stromrichter nach dem Oberbegriff des Anspruchs 1. Eine derartige Anordnung ist aus der EP-A-0 783 199 bekannt.

Anordnungen nach dem Oberbegriff des Anspruchs 1 sind als sogenannte Schienenpakete bekannt und werden zum Aufbau z.B. von Wechselrichtern mit schnell schaltenden Leistungshalbleiterschaltern verwendet. Die bekannten Schienenpakete besitzen beispielsweise einen laminierten Aufbau aus zwei als Leiter dienenden Kupferplatten mit einer dazwischen angeordneten Platte oder Folie aus einem Festkörperisolator. Der Abstand der Kupferplatten ist gering, so dass die Schienenpakete dazu geeignet sind, hohe Ströme mit einer geringen Induktivität zu führen. Die erforderliche Spannungsfestigkeit der Schienenpakete von beispielsweise 1000 Volt wird durch den zwischen den Kupferplatten angeordneten Festkörperisolator erreicht.

Aufgrund von sogenannten Teilentladungen zwischen den Kupferplatten ist der dazwischen angeordnete Festkörperisolator einer Alterung unterworfen, die eine Verminderung der Spannungsfestigkeit zur Folge hat. Allgemein wird versucht, diesen Nachteil durch immer bessere Isolationsmaterialien auszugleichen.

Bei der EP-A-0 783 199 sind die beiden Leiterplatten an ihren Rändern mit Hilfe von Isolierelementen eingespannt. Ansonsten befindet sich zwischen den Leiterplatten keine isolierende Platte o. dgl. , sondern Luft. An den vorgenannten Isolierelementen treten jedoch dieselben Probleme auf, wie sie bereits allgemein für Festkörperisolatoren erläutert wurden. Insbesondere führen Teilentladungen zu einer Alterung der Isolierelemente und damit zu einer verminderten Spannungsfestigkeit.

Aufgabe der Erfindung ist es, eine Anordnung zur niederinduktiven Führung hoher Ströme zu schaffen, die eine von Alterungserscheinungen möglichst unabhängige Spannungsfestigkeit besitzt.

Diese Aufgabe wird bei einer Anordnung der eingangs genannten Art durch die Erfindung vorteilhafterweise dadurch gelöst, dass der Raum zwischen den beiden Leitern keinen Übergang von dem einen der beiden Leiter zu einem Festkörperisolator und von dort zu dem anderen der beiden Leiter enthält.

Bei der Erfindung ist der Raum zwischen den beiden Leitern durch die von den beiden Leitern gebildeten Leiterflächen sowie durch die zwischen den Rändern der beiden Leiter gebildeten Verbindungsflächen gebildet.

Weiterhin enthält der Raum zwischen den beiden Leitern ein nicht-festes, isolierendes Medium, vorzugsweise Luft.

Damit wird gewährleistet, dass derjenige Bereich, der von der zwischen den beiden Leitern vorhandenen Spannung beaufschlagt wird, keinerlei Material eines Festkörperisolators enthält. Stattdessen ist in diesem Bereich vorzugsweise nur Luft vorhanden. Es können somit in diesem gefährdeten Bereich keinerlei Alterungserscheinungen von isolierenden Materialien entstehen.

Zwischen den Leitern ist also kein Festkörperisolator vorhanden. Damit können auch keine durch Teilentladungen hervorgerufene Alterungserscheinungen in dem Festkörperisolator entstehen. Eine Verminderung der Spannungsfestigkeit aufgrund derartiger Alterungserscheinungen ist damit ebenfalls nicht möglich. Bei der erfindungsgemäßen Anordnung ist somit die Spannungsfestigkeit zwischen den Leitern im wesentlichen unabhängig von der Alterung der verwendeten Materialien. Dies bringt den wesentlichen Vorteil mit sich, dass die erfindungsgemäße Anordnung über einen längeren Zeitraum funktionssicher arbeitet. Ein weiterer Vorteil der Erfindung besteht darin, dass aufgrund des nichtvorhandenen Festkörperisolators wesentlich höhere Spannungen zwischen den beiden Leitern angelegt werden können, ohne dass hierdurch die Funktionsfähigkeit der erfindungsgemäßen Anordnung in Mitleidenschaft gezogen wird.

Finden zwischen den Leitern der erfindungsgemäßen Anordnung Teilentladungen statt, so haben diese keine Schädigung des dazwischen vorhandenen nicht-festen, isolierenden Mediums zur Folge. Gleichzeitig wird aber durch das isolierende Medium die erforderliche Isolation zwischen den beiden Leitern in einfacher Weise erreicht.

Insbesondere die Verwendung von Luft als Isolator bringt den wesentlichen Vorteil mit sich, dass einerseits eine hohe Spannungsfestigkeit durch eine entsprechende Wahl des Abstands der beiden Leiter erreichbar ist, und dass andererseits der Aufwand und die daraus resultierenden Kosten für diese erfindungsgemäße Anordnung besonders gering sind.

Bei einer vorteilhaften Weiterbildung der Erfindung sind die beiden Leiter auf ihren einander abgewandten Flächen mittels jeweils einer Halterung gehalten. Die Halterungen sind also nicht in dem vorstehend genannten gefährdeten Bereich vorhanden. Damit sind die Halterungen, die vorzugsweise aus einem isolierendem Material bestehen, keiner Alterung aufgrund von Teilentladungen ausgesetzt. Die Halterungen besitzen somit eine über einen großen Zeitraum gewährleistete Funktionssicherheit mit den bereits erwähnten Vorteilen.

Bei einer weiteren vorteilhaften Weiterbildung der Erfindung sind die beiden Leiter außerhalb des zwischen ihnen vorhandenen Raums mittels zweier Verbindungen miteinander verbunden. Die Verbindungen sind somit nicht in dem vorstehend erwähnten gefährdeten Bereich angeordnet. Da die Isolationsstrecke dieser isolierenden Verbindungen unabhängig vom Abstand zwischen den Leitern ist und somit bei kleiner Induktivität hinreichend groß gewählt werden kann, sind Alterungserscheinungen der Verbindungen aufgrund von Teilentladungen im Wesentlichen ausgeschlossen.

Besonders vorteilhaft ist es, wenn die Halterungen an den Verbindungen angebracht sind. Auf diese besonders einfache und effektive Weise wird ein konstruktiv stabiler, und trotzdem kostengünstiger Aufbau der erfindungsgemäßen Anordnung erreicht.

Bei einer vorteilhaften Weiterbildung der Erfindung sind die beiden Leiter versetzt zueinander angeordnet. Damit ist es möglich, eine Verlängerung der über die Halterungen und Verbindungen entstehenden Isolationsstrecken zwischen den beiden Leitern zu erreichen. Die Spannungsfestigkeit der erfindungegemäßen Anordnung kann damit ohne einen größeren Aufwand weiter verbessert werden.

Bei einer vorteilhaften Ausgestaltung der Erfindung ist einer der beiden Leiter auf seiner dem anderen der beiden Leiter zugewandten Fläche mit einem Festkörperisolator versehen. Damit entsteht ein Übergang zwischen dem einen der beiden Leiter zu dem Festkörperisolator. Ein weiterer Übergang von dem Festkörperisolator zu dem anderen der beiden Leiter ist jedoch nicht vorhanden. Stattdessen ist dort das nicht-feste, isolierende Medium, vorzugsweise Luft vorhanden. Der Festkörperisolator dient nicht primär dem Aufbau der Spannungsfestigkeit zwischen den beiden Leitern. Dies wird primär weiterhin durch das nicht-feste, isolierende Medium erreicht. Der Festkörperisolator hat im wesentlichen nur die Aufgabe, einen Kurzschluß zwischen den beiden Leitern zu vermeiden, wenn z.B. ein Metallteil zwischen die Leiter gelangt. Da der Festkörperisolator damit keinen Einfluß auf die Spannungsfestigkeit hat, bringen auch Teilentladungen in dem Festkörperisolator keine nachteiligen Folgen für diese Spannungsfestigkeit mit sich. Der Festkörperisolator stellt damit einen einfachen und kostengünstigen Schutz gegen einen möglichen Kurzschluß zwischen den beiden Leitern dar.

Bei einer weiteren vorteilhaften Ausgestaltung der Erfindung ist der Raum zwischen den beiden Leitern von einem Schutzgitter oder dergleichen umgeben und/oder er ist zur Kontrolle von außen einsehbar. Damit kann auf besonders einfache und kostengünstige, aber trotzdem effektive Weise ein Kurzschluß zwischen den beiden Leitern verhindert werden.

Weitere Merkmale, Anwendungsmöglichkeiten und Vorteile der Erfindung ergeben sich aus der nachfolgenden Beschreibung von Ausführungsbeispielen der Erfindung, die in den Figuren der Zeichnung dargestellt sind. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung sowie unabhängig von ihrer Formulierung bzw. Darstellung in der Beschreibung bzw. in der Zeichnung.
- Figur 1: zeigt eine schematische Darstellung einer beispielhaften Schaltung, in der eine erfindungsgemäße Anordnung zur niederinduktiven Führung hoher Ströme enthalten sein kann, und
- Figur 2: zeigt eine schematische Perspektivdarstellung eines Ausführungsbeispiels einer erfindungsgemäßen Anordnung.

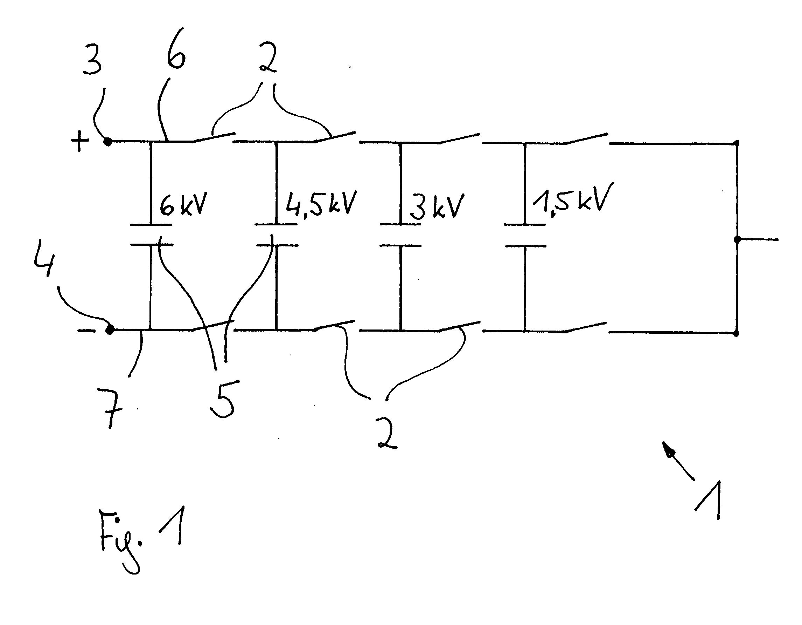

In der Figur 1 ist schematisch ein Wechselrichter 1 dargestellt, der mit schnell schaltenden und hochsperrenden Leistungshalbleiterschaltern 2, beispielsweise mit sogenannten Insulated Gate Bipolar Transistors (IGBT's) versehen ist. Der Wechselrichter 1 ist mit einem Pluspol 3 und einem Minuspol 4 versehen, zwischen denen Kondensatoren 5 vorhanden sind. Liegt beispielsweise zwischen dem Plus-und dem Minuspol 3, 4 eine Spannung von 6000 Volt an, so wird diese Spannung über die Schalter 2 auf die Kondensatoren 5 heruntergebrochen. An dem unmittelbar an dem Plus- und Minuspol 3, 4 anliegenden Kondensator 5 liegt dann eine Spannung von 6000 Volt an, an dem nächsten Kondensator 5 eine Spannung von 4500 Volt, an dem übernächsten Kondensator 5 eine Spannung von 3000 Volt und an dem letzten der in der Figur 1 dargestellten Kondensatoren 5 eine Spannung von 1500 Volt.

Der mit dem Pluspol 3 verbundene Leitungsstrang 6 stellt eine obere Lage eines sogenannten Schienenpakets dar, und der mit dem Minuspol 4 verbundene Leitungsstrang 7 eine untere Lage des Schienenpakets. Die in der Figur 1 gezeigten Schalter 2 und Kondensatoren 5 sind mit diesen Lagen des Schienenpakets elektrisch verbunden.

Die obere und die untere Lage des Schienenpakets sind von flächigen Leitern gebildet, die etwa parallel und mit einem Abstand zueinander angeordnet sind. Ebenfalls sind die obere und die untere Lage voneinander isoliert. Damit sind die obere und die untere Lage dazu geeignet, hohe Ströme mit niederen Induktivitäten zu führen. Bei dem Schienenpaket handelt es sich somit um eine Anordnung zur niederinduktiven Führung hoher Ströme, die bei einem Stromrichter oder dergleichen verwendet werden kann.

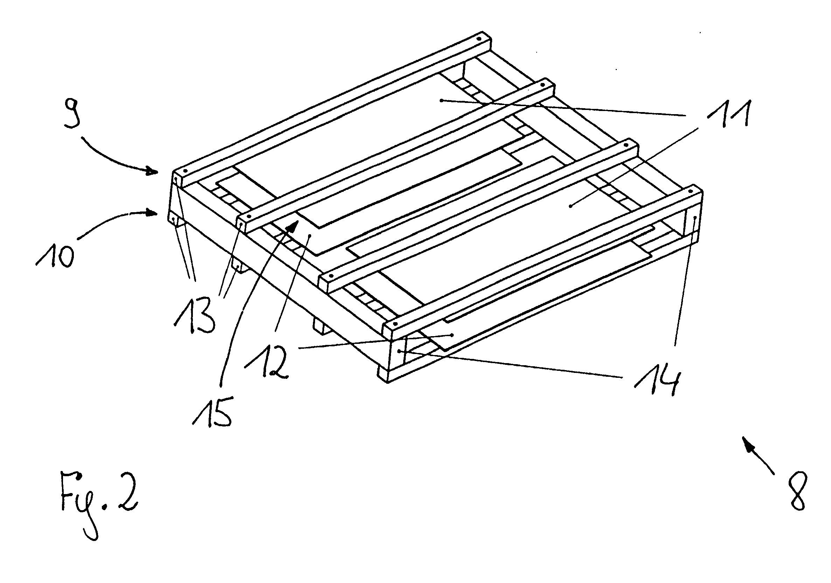

In der Figur 2 ist eine Anordnung 8 dargestellt, die ein derartiges Schienenpaket darstellt. Mit der Anordnung 8 der Figur 2 können beispielsweise die Leitungsstränge 6, 7 der Figur 1 insbesondere unmittelbar bei dem Plus- und dem Minuspol 3, 4 der Figur 1, also bei dem Kondensator 5 mit 6000 Volt der Figur 1, realisisert werden.

Die Anordnung 8 der Figur 2 weist eine obere Lage 9 und eine untere Lage 10 auf, in denen jeweils zwei flächige elektrische Leiter 11, 12 angeordnet sind. Die Leiter 11, 12 können beispielsweise aus Kupferplatten oder dergleichen bestehen.

Die Leiter 11 der oberen Lage 9 und die Leiter 12 der unteren Lage 10 sind etwa parallel zueinander angeordnet und weisen einen Abstand zueinander auf. Die Leiter 11, 12 sind im wesentlichen eben ausgebildet.

Auf ihren einander abgewandten Flächen sind die Leiter 11, 12 mit Halterungen 13 versehen, die beispielsweise in der Form von geraden Streben ausgebildet sind, und die über die von den Leitern 11, 12 gebildeten Flächen überstehen. Die Halterungen 13 sind aus einem isolierenden Material hergestellt und sind fest mit den Leitern 11, 12 verbunden. Jeder der Leiter 11, 12 ist beispielsweise mit zwei etwa parallelen Halterungen 13 versehen.

Die vier in einer der beiden Lagen 9, 10 vorhandenen Halterungen 13 sind über eine z.B. aus einer geraden Strebe bestehenden Verbindung 14 miteinander verbunden. Zu diesem Zweck sind zwei etwa parallele Verbindungen 14 zur Verbindung der Halterungen 13 der oberen Lage 9 mit den Halterungen 13 der unteren Lage 9 vorgesehen. Diese Verbindungen 14 sind vorzugsweise aus einem isolierenden Material hergestellt und sind fest mit den Halterungen 13 verbunden.

Die Verbindung zwischen den Halterungen 13 und den Verbindungen 14 ist dabei außerhalb der von den Leitern 11, 12 gebildeten Flächen, also in dem überstehenden Bereich der Halterungen 13 vorgesehen.

Es wird nunmehr einer der beiden Leiter 11 der oberen Lage 9 und der diesem Leiter 11 zugehörige, gegenüber angeordnete Leiter 12 der unteren Lage 10 betrachtet. Zwischen diesen beiden Leitern 11, 12 ist ein Raum 15 vorhanden, der festgelegt wird durch die Leiterflächen der beiden Leiter 11, 12 sowie durch die Verbindungsflächen zwischen den Rändern der beiden Leiter 11, 12.

Wie aus der Figur 2 ersichtlich ist, ist in diesem Raum 15 kein Übergang von einem der beiden Leiter 11, 12 zu einem Festkörperisolator und von diesem Festkörperisolator zu dem anderen der beiden Leiter 11, 12 vorhanden. Stattdessen ist in diesem Raum 15 nur Luft vorhanden. Anstelle von Luft kann in diesem Raum 15 auch ein sonstiges nicht-festes isolierendes Medium vorhanden sein.

Wie ebenfalls aus der Figur 2 ersichtlich ist, ist in dem Raum 15 keine der Halterungen 13 oder Verbindungen 14 vorhanden. Diese Halterungen 13 und Verbindungen 14 sind alle außerhalb des Raums 15 angeordnet.

Wie erläutert, sind die Leiter 11, 12 der oberen und der unteren Lage 9, 10 durch den mit Luft gefüllten Raum 15 und durch die Halterungen 13 und Verbindungen 14 aus isolierendem Material voneinander elektrisch isoliert. Da in dem Raum 15 kein Festkörperisolator enthalten ist, kann dort auch keine Teilentladung in einem derartigen Festkörperisolator entstehen. Der mit Luft gefüllte Raum 15 zwischen den Leitern 11, 12 stellt damit eine im wesentlichen alterungsfreie Isolation zwischen den beiden Leitern 11, 12 dar.

Die Halterungen 13 und die Verbindungen 14 sind außerhalb des Raums 15 angeordnet. Die Isolationsstrecke kann somit unabhängig vom Abstand zwischen den beiden Leitern 11, 12 entsprechend der erforderlichen Teilentladungsfestigkeit angemessen groß ausgelegt werden. Auch insoweit kann damit im wesentlichen keine alterungsbedingte Verminderung der Isolation zwischen den beiden Leitern 11, 12 entstehen.

Die Spannungsfestigkeit zwischen den beiden Leitern 11, 12 kann durch die Wahl des Abstands zwischen den beiden Leitern 11, 12 beeinflußt werden. Ebenfalls kann diese Spannungsfestigkeit durch eine entsprechende Ausbildung der Halterungen 13 und Verbindungen 14 beeinflußt werden, insbesondere durch die Ausbildung einer möglichst langen Isolationsstrecke über die Halterungen 13 und die Verbindungen 14.

Diese Isolationsstrecke zwischen den beiden Leitern 11, 12 über die Halterungen 13 und die Verbindungen 14 kann dadurch verlängert werden, daß die Leiter 11 der oberen Lage 9 versetzt zu den Leitern 12 der unteren Lage 10 angeordnet werden.

Es besteht die Möglichkeit, daß ein Kurzschluß zwischen den beiden Leitern 11, 12 beispielsweise dadurch entsteht, daß zwischen die beiden Leiter 11, 12 unbeabsichtigterweise ein elektrisch leitfähiger Gegenstand, z.B. ein Metallteil gelangt. Zur Vermeidung eines derartigen Kurzschlußes kann vorgesehen sein, daß einer der beiden Leiter 11, 12 auf seiner dem anderen Leiter zugewandten Fläche mit einem Festkörperisolator versehen ist, vorzugsweise mit einer Isolationsfolie oder dergleichen.

In diesem Fall wird ein Übergang geschaffen zwischen einem der beiden Leiter 11, 12 und der Isolationsfolie. Der andere der beiden Leiter 11, 12 besitzt jedoch keinen unmittelbaren Übergang zu der Isolationsfolie. Zwischen diesem anderen der beiden Leiter 11, 12 und der Isolationsfolie ist - wie bereits erläutert - Luft oder ein sonstiges nicht-festes, isolierendes Medium vorhanden.

Die Isolationsfolie ist derart ausgelegt, daß sie eine Sapnnungsfestigkeit entsprechend der zwischen den beiden Leitern 11, 12 vorhandenen Spannung besitzt. Damit entstehen nur dann Teilentladungen in der Isolationsfolie, wenn ein Metallteil zwischen die Leiter 11, 12 gelangt. Aufgrund der Spannungsfestigkeit der Isolationsfolie kommt es jedoch nicht zu einem Kurzschluß.

Damit die Isolationsfolie im normalen Betrieb, also ohne ein zwischen den Leitern 11, 12 befindliches Metallteil, nicht durch Teilentladungen geschädigt wird, können die Abmessungen der Isolationen in der Luft und in der Isolationsfolie, wie auch die Dielektrizitätskonstante der Isolationsfolie derart gewählt werden, daß die Spannungsbeanspruchung der Isolationsfolie kleiner wird als die sogenannte Teilentladungsaussetzspannung.

Eine weitere Möglichkeit, die beiden Leiter 11, 12 vor einem Kurzschluß durch dazwischen befindliche Metallteile zu schützen, kann darin bestehen, daß der Raum 15 zwischen den beiden Leitern 11, 12 von einem Schutzgitter oder dergleichen umgeben ist. Eine weitere alternative oder zusätzliche Möglichkeit, einen Kurzschluß zu vermeiden oder zumindest frühzeitig zu entdecken, kann darin bestehen, daß der Raum 15 zwischen den beiden Leitern 11, 12 zur Kontrolle von außen einsehbar ist.

## Patentansprüche

1. Anordnung (8) zur niederinduktiven Führung hoher Ströme insbesondere für einen Stromrichter, mit zwei flächigen elektrischen Leitern (11, 12), die etwa parallel in einem Abstand zueinander angeordnet und voneinander isoliert sind, wobei zwischen den beiden Leitern (11, 12) durch die von den beiden Leitern (11, 12) gebildeten Leiterflächen sowie durch die zwischen den Rändern der beiden Leiter (11, 12) gebildeten Verbindungsflächen ein Raum (15) gebildet ist, und wobei der Raum (15) zwischen den beiden Leitern (11, 12) ein nicht-festes, isolierendes Medium, vorzugsweise Luft enthält, **dadurch gekennzeichnet, dass** der Raum (15) zwischen den beiden Leitern (11, 12) keinen Übergang von dem einen der beiden Leiter (11, 12) zu einem Festkörperisolator und von dort zu dem anderen der beiden Leiter (11, 12) enthält.

2. Anordnung (8) nach Anspruch 1, **dadurch gekennzeichnet, dass** die beiden Leiter (11, 12) auf ihren einander abgewandten Flächen mittels jeweils einer Halterung (13) gehalten sind.

3. Anordnung (8) nach einem der Ansprüche 1 oder 2, **dadurch gekennzeichnet, dass** die beiden Leiter (11, 12) außerhalb des zwischen ihnen vorhandenen Raums (15) mittels zweier Verbindungen (14) miteinander verbunden sind.

4. Anordnung (8) nach Anspruch 2 und 3, **dadurch gekennzeichnet, dass** die Halterungen (13) an den Verbindungen (14) angebracht sind.

5. Anordnung (8) nach einem der Ansprüche 1 bis 4, **dadurch gekennzeichnet, dass** die beiden Leiter (11, 12) versetzt zueinander angeordnet sind.

6. Anordnung (8) nach einem der Ansprüche 1 bis 5, **dadurch gekennzeichnet, dass** einer der beiden Leiter (11, 12) auf seiner dem anderen der beiden Leiter (11, 12) zugewandten Fläche mit einem Festkörperisolator versehen ist.

7. Anordnung (8) nach einem der Ansprüche 1 bis 6, **dadurch gekennzeichnet, dass** der Raum (15) zwischen den beiden Leitern (11, 12) von einem Schutzgitter oder dergleichen umgeben ist und/oder zur Kontrolle von außen einsehbar ist.

## Claims

1. Arrangement (8) for low-induction conduction of large currents, in particular for a power converter, comprising two sheet-like electrical conductors (11, 12) arranged approximately parallel and at a distance from one another and insulated from one another, wherein a chamber (15) is formed between the two conductors (11, 12) by the conductor surfaces formed by the two conductors (11, 12) and by the connecting surfaces formed between the edges of the two conductors (11, 12) and wherein the chamber (15) between the two conductors (11, 12) contains a non-solid insulating medium, preferably air, **characterised in that** the chamber (15) between the two conductors (11, 12) does not contain any transition from one of the two conductors (11, 12) to a solid body insulator and from there to the other of the two conductors (11, 12).

2. Arrangement (8) according to claim 1, **characterised in that** the two conductors (11, 12) are held on their surfaces facing away from one another, in each case, by means of a support (13).

3. Arrangement (8) according to one of the claims 1 or 2, **characterised in that** the two conductors (11, 12) are connected to one another outside the chamber (15) existing between them by means of two connectors (14).

4. Arrangement (8) according to claim 2 and 3, **characterised in that** the supports (13) are mounted on the connectors (14).

5. Arrangement (8) according to one of the claims 1 to 4, **characterised in that** the two conductors (11, 12) are arranged offset from one another.

6. Arrangement (8) according to one of the claims 1 to 5, **characterised in that** one of the two conductors (11, 12) is provided on its surface facing toward the other conductor (11, 12) with a solid body insulator.

7. Arrangement (8) according to one of the claims 1 to 6, **characterised in that** the chamber (15) between the two conductors (11, 12) is surrounded by a protective grid or the like and/or can be looked into from outside for monitoring.

## Revendications

1. Dispositif (8) pour conduire des courants élevés sous faible inductance, en particulier pour un redresseur, comportant deux conducteurs électriques plans (11, 12), disposés à distance l'un de l'autre, sensiblement parallèles entre eux et isolés l'un de l'autre, un espace (15) étant formé entre les deux conducteurs (11, 12) par les surfaces conductrices formées par les deux conducteurs (11, 12) et par les surfaces de liaison formées entre les bords des deux conducteurs (11, 12), et l'espace (15) formé entre les deux conducteurs (11, 12) contenant un milieu isolant non solide, par exemple de l'air, **caractérisé en ce que** l'espace (15) entre les deux conducteurs (11, 12) ne comprend aucune transition entre l'un des deux conducteurs (11, 12) et un isolateur solide ni entre ce dernier et le deuxième des deux conducteurs (11, 12).

2. Dispositif (8) selon la revendication 1, **caractérisé en ce que** les deux conducteurs (11, 12) sont chacun maintenus au niveau de leurs surfaces opposées au moyen d'un élément de maintien (13).

3. Dispositif (8) selon la revendication 1 ou la revendication 2, **caractérisé en ce que** les deux conducteurs (11, 12) sont reliés l'un à l'autre en dehors de l'espace (15) formé entre eux au moyen de deux éléments de liaison (14).

4. Dispositif (8) selon les revendications 2 et 3, **caractérisé en ce que** les éléments de maintien (13) sont rapportés sur les éléments de liaison (14).

5. Dispositif (8) selon l'une quelconque des revendications 1 à 4, **caractérisé en ce que** les deux conducteurs (11, 12) sont décalés l'un par rapport à l'autre.

6. Dispositif (8) selon l'une quelconque des revendications 1 à 5, **caractérisé en ce que** l'un des deux conducteurs (11, 12) est doté d'un isolateur solide sur sa face en regard de l'autre des deux conducteurs (11, 12).

7. Dispositif (8) selon l'une quelconque des revendications 1 à 6, **caractérisé en ce que** l'espace (15) formé entre les deux conducteurs (11, 12) est entouré d'une grille protectrice ou similaire et/ou est visible de l'extérieur à des fins de surveillance.
